# EUROPEAN PATENT SPECIFICATION

(11) **EP 4 503 870 B1**
(45) Date of publication and mention of the grant of the patent: **01.07.2026**
(21) Application number: 24190895.3
(22) Date of filing: 25.07.2024
(51) Int. Cl.: H05K 3/00, H05K 1/02, H10W 40/00, H10W 40/25, H10W 40/47, H05K 1/00, H10W 40/22, H10W 40/73

(54) **MANUFACTURING METHOD OF HEAT DISSIPATION DEVICE-INTEGRATED HEAT DISSIPATION SUBSTRATE FOR SEMICONDUCTOR**
HERSTELLUNGSVERFAHREN FÜR EIN WÄRMEABLEITUNGSVORRICHTUNGSINTEGRIERTES WÄRMEABLEITUNGSSUBSTRAT FÜR HALBLEITER
PROCÉDÉ DE FABRICATION D'UN SUBSTRAT DE DISSIPATION DE CHALEUR INTÉGRÉ À UN DISPOSITIF DE DISSIPATION DE CHALEUR POUR SEMI-CONDUCTEUR

(30) Priority: 01.08.2023 KR 20230100207
(43) Date of publication of application: 05.02.2025
(73) Proprietor: IMH Inc., Ansan-si, Gyeonggi-do 15418 (KR)
(72) Inventor: LEE, Jong Eun, 15418 Ansan-si, Gyeonggi-do (KR)
(74) Representative: BCKIP Part mbB

(56) References cited:
- WO-A1-2008/075409
- US-A- 5 666 269
- US-A1- 2020 036 159
- US-A1- 2022 223 435
- US-A1- 2022 377 939

## Description

### Technical Field

The present invention relates to a manufacturing method of a heat dissipation device-integrated heat dissipation substrate for mounting a semiconductor device. More particularly, the present invention relates to a heat dissipation substrate serving as a circuit substrate for mounting a semiconductor device, and to a manufacturing method for efficiently manufacturing a heat dissipation substrate provided with a thick electrode metal plate suitable for mounting high-power semiconductor device or high-output LED and having a heat dissipation device integrated with a rear surface of the electrode metal plate.

### Background Art

Recently, in the field of electric power industry, research and development are being actively conducted to improve the efficiency of devices that operate using electricity as a power source such as electric vehicles and robots, as well as research and development on facilities for new renewable energy such as sunlight generation or wind power generation. A core part used in this technology is a power module using a power device, i.e., a power semiconductor module. Also in the lighting field, research and development of technologies are being conducted to improve efficiency and lifetime of an LED light source requiring high power, such as a vehicle headlight, a streetlamp, or a plant growth light for smart farm.

Since these power devices handle with high power, with a current ranging from several dozens to several hundreds of amperes, and a voltage ranging from several dozens to several thousands of volts, a considerable amount of heat may be generated from the device module. The heat causes a malfunction and reliability problem of the corresponding device. In order to prevent such defects or reduced efficiency, it has become very important to rapidly dissipate heat generated from a semiconductor device. Even in the case of a high-output LED light source module, heat dissipation is a critical factor to decide the lifetime and efficiency of the corresponding device. Heat dissipation is also a very important factor in computing devices for artificial intelligence or cloud computing.

A general printed circuit board is one in which an electrode pattern is formed on an electrode layer made of copper foil through an etching or plating process. When the copper foil is thin, the electrical resistance is large, making it unsuitable for the aforementioned high-power semiconductor devices. When the copper foil is thick, the etching or plating process reaches its limits. In order to solve the technical problem of securing an electrode pattern of sufficient thickness, the applicant has proposed a configuration and a manufacturing method that can improve the performance, durability, and productivity of heat dissipation substrates for semiconductors and reduce pollutant emissions by cutting all or part of the thickness of an electrode metal layer through Registered Patents No. 10-2055587, No. 10-2283906, and No. 10-2120785.

On the other hand, in order to obtain a sufficient heat dissipation effect for high-power semiconductor devices or the like on printed circuit boards, it is often required to separately attach heat dissipation devices such as heat sinks, water jackets, heat pipes, or heat exchangers. The problem is that the heat conduction resistance of a coupling surface for attaching these heat dissipation devices to the printed circuit board is high, and circuit defects may occur in the process of coupling the heat dissipation devices to the printed circuit board. For example, when the rear surface of the printed circuit board and the water jacket are bonded through brazing, the process temperature reaches about 600°C, which may damage a synthetic resin insulating layer constituting the printed circuit board and may cause the placement of electrodes to be misaligned.

WO2008/075409A1 discloses a base for a power module comprising a heat dissipation substrate made of a high heat conductivity material, an insulating substrate bonded to one side of the heat dissipation substrate, and a wiring layer provided on the side of the insulating substrate opposite to the side bonded to the heat dissipation substrate.

US 5 666 269 A discloses a liquid cooled power dissipation apparatus including a metal matrix composite heat sink with an insulation layer integral to the apparatus. The insulation layer is made integral to the apparatus during infiltration of the metal matrix composite heat sink. Electronic components are situated on top of the insulation layer.

### DISCLOSURE OF THE INVENTION

### Technical Problem

The present invention is directed to providing a method for manufacturing a heat dissipation substrate for a semiconductor for mounting a high-power semiconductor device, a heat dissipation device-integrated heat dissipation substrate for a semiconductor in which a heat dissipation device such as a water jacket, a refrigerant circulation heat exchanger, and a heat pipe is integrated on the rear surface of a printed circuit board, and a method for efficiently manufacturing the heat dissipation substrate. Also, The present invention is directed to providing a method for manufacturing a heat dissipation device-integrated heat dissipation substrate for a semiconductor, with which a heat dissipation device is integrated, without any damage to a circuit board having a synthetic resin insulating layer.

### Technical Solution

To this end, the present invention provides a manufacturing method of a heat dissipation device-integrated heat dissipation substrate for a semiconductor in accordance with claim 1.

According to the present invention, a manufacturing method of a heat dissipation device-integrated heat dissipation substrate for a semiconductor, the heat dissipation substrate used to mount a semiconductor device and including a plurality of electrodes separated from each other by a pattern space and electrically insulated from each other, a metal base integrated with a heat media circulation space for absorbing and dissipating heat transferred from the plurality of electrodes, and an insulating layer made of insulating resin and bonding the plurality of electrodes to the metal base, may include: a base processing step of preparing a first base plate and a second base plate in the form of metal plates that overlap each other and constitute at least a part of the metal base, and providing a first base and a second base in which a three-dimensional structure forming the heat media circulation space is formed on an inner surface of at least one of the first base plate and the second base plate; a base coupling step of coupling opposing inner surfaces of the first base and the second base against each other to form a heat dissipation device-integrated base including the heat media circulation space; an electrode metal plate preparation step of processing an electrode metal plate to form a groove pattern corresponding to the pattern space, the electrode metal plate being a metal plate material serving to constitute the plurality of electrodes, and preparing the electrode metal plate configured to cover an area corresponding to at least one circuit unit by a remaining portion left when the groove pattern is formed, without generating an opening; and an electrode metal plate bonding step of bonding, via insulating resin, the electrode metal plate to an upper surface of the heat dissipation device-integrated base formed in the base coupling step.

According to the present invention, in the base coupling step, the first base and the second base are bonded to each other through a brazing process.

In the electrode metal plate bonding step, an insulating layer may be formed between a first surface of the electrode metal plate formed with the groove pattern and an upper surface of the heat dissipation device-integrated base, and bonding may be performed so that the groove pattern may be filled with an insulator.

In the electrode metal plate bonding step, the insulating layer may be formed using a semi-cured insulating resin sheet.

The manufacturing method may include an electrode forming step of separating the plurality of electrodes from each other by deleting the remaining portion from an upper surface of the electrode metal plate after the electrode metal plate bonding step.

In the base processing step and the base coupling step, a plurality of heat dissipation device units each including the heat media circulation space formed between two opposing inner surfaces of the first and second bases and selected from a group including a water jacket, a heat exchanger, and a heat pipe may be integrally formed by processing the first and second bases and coupling the first and second bases.

In the base processing step, the first and second bases may be processed so that the plurality of heat dissipation device units are arranged in a planar manner within the heat dissipation device-integrated base.

In the electrode metal plate preparation step, a plurality of groove pattern units may be disposed on the electrode metal plate, each of which constituting one circuit and corresponding to each of the plurality of heat dissipation device units,
and the manufacturing method may further comprises: a cutting step of cutting a plate which is formed by the electrode metal plate bonding step bonding the electrode metal plate and the heat dissipation device-integrated base with the insulating resin, to form a plurality of heat dissipation device-integrated heat dissipation substrate units for a semiconductor. In the base processing step, the first and second bases may be processed so that the one heat dissipation device unit is configured in the heat dissipation device-integrated base, and
in the electrode metal plate preparation step and the electrode metal plate bonding step, a plurality of electrode metal plates each formed with a groove pattern corresponding to one circuit unit may be prepared and bonded to the upper surface of the heat dissipation device-integrated base.

According to an embodiment, a manufacturing method of a heat dissipation device-integrated heat dissipation substrate for a semiconductor, the heat dissipation substrate used to mount a semiconductor device and including a plurality of electrodes separated from each other by a pattern space and electrically insulated from each other, a metal base integrated with a heat media circulation space for absorbing and dissipating heat transferred from the plurality of electrodes, and an insulating layer made of insulating resin and bonding the plurality of electrodes to the metal base, may include: a base processing step of preparing a first base plate and a second base plate in the form of metal plates that overlap each other and constitute at least a part of the metal base, and providing a first base and a second base in which a three-dimensional structure forming the heat media circulation space is formed on an inner surface of at least one of the first base plate and the second base plate; a base coupling step of coupling opposing inner surfaces of the first base and the second base against each other to form heat dissipation device-integrated base including the heat media circulation space; an electrode metal plate bonding step of bonding an electrode metal plate in the form of a flat plate to an upper surface of the heat dissipation device-integrated base via insulating resin; and an electrode forming step of forming the plurality of electrodes on the electrode metal plate by deleting a pattern corresponding to the pattern space.

In the base processing step, a plurality of cooling fins may be formed protruding from a bottom surface of the first base, and in the base coupling step, distal ends of the plurality of cooling fins may be coupled to a bottom surface of a three-dimensional structure forming the heat media circulation space of the second base to be fixedly supported at least in a transverse direction parallel to a plane to which at least the second base belongs.

In the base processing step, a plurality of fin grooves may be formed on the bottom surface to accommodate the distal ends of the plurality of cooling fins, and in the base coupling step, the first and second bases may be coupled to each other in a state in which the distal ends of the plurality of cooling fins are inserted into the plurality of fin grooves, respectively.

In the base coupling step, inner surfaces of each of the first and second bases may be brazed to each other, and the distal ends of the plurality of cooling fins may be brazed to the bottom surface.

A heat dissipation device for a semiconductor integrated with a heat dissipation device may include: a first base including a flat upper surface, an electrode pattern constituting a predetermined circuit being bonded to the upper surface via an insulating layer; a second base disposed below the first base, coupled to face a bottom surface of the first base, and formed with a three-dimensional structure forming a heat media circulation space between the second base and the bottom surface of the first base; and a plurality of cooling fins protruding from the bottom surface of the first base toward the heat media circulation space, wherein distal ends of the plurality of cooling fins are fixedly supported on a bottom surface of the three-dimensional structure inside the second base.

The second base may further include a plurality of fin grooves on the bottom surface to accommodate the distal ends of the plurality of cooling fins, and the first base and the second base may be coupled to each other in a state in which the distal ends of the plurality of cooling fins are inserted into the plurality of fin grooves.

### Advantageous Effects

The present invention provides a method for efficiently manufacturing, as a heat dissipation substrate for a semiconductor for mounting a high-power semiconductor device, a heat dissipation device-integrated heat dissipation substrate for a semiconductor in which a heat dissipation device such as a water jacket, a refrigerant circulation heat exchanger, and a heat pipe is integrated on the rear surface of a printed circuit board. The present invention can manufacture a heat dissipation device-integrated heat dissipation substrate for a semiconductor without any damage to a circuit board having a synthetic resin insulating layer. A manufacturing method in accordance with the present invention can be applied to mass production as well as small quantity production of various types.

### Brief Description of Drawings

FIG. 1 illustrates a preparation state of first and second base plates during a manufacturing process in accordance with an embodiment of the present invention.
FIGS. 2A and 2B illustrate a first base processing state during a manufacturing process in accordance with an embodiment of the present invention.
FIGS. 3A and 3B illustrate a second base processing state during a manufacturing process in accordance with an embodiment of the present invention.
FIG. 4 illustrates a heat dissipation device-integrated base in which a first base in FIG. 2 and a second base in FIG. 3 are bonded.
FIG. 5 illustrates a processing state of a first side of an electrode metal plate during a manufacturing process in accordance with an embodiment of the present invention.
FIG. 6 illustrates a state in which an electrode metal plate in FIG. 5 is bonded to a heat dissipation device-integrated base in FIG. 4.
FIG. 7 illustrates a state before cutting a plate of a heat dissipation substrate for a semiconductor in accordance with an embodiment of the present invention.
FIGS. 8A and 8B illustrate first and second base processing states during a manufacturing process in accordance with an embodiment of the present invention.
FIG. 9 illustrates a state before cutting a plate of a heat dissipation substrate for a semiconductor to which first and second bases in FIG. 8 are applied.
FIG. 10 illustrates a manufacturing process of a heat dissipation device-integrated base during a manufacturing process of a heat dissipation device-integrated heat dissipation substrate for a semiconductor in accordance with an embodiment of the present invention.
FIG. 11 illustrates an assembled state of a heat dissipation device-integrated base during a manufacturing process of a heat dissipation device-integrated heat dissipation substrate for a semiconductor in accordance with an embodiment of the present invention.
FIG. 12 illustrates an electrode metal plate preparation step during a manufacturing process of a heat dissipation device-integrated heat dissipation substrate for a semiconductor in accordance with an embodiment of the present invention.
FIG. 13 illustrates a bonding step of an electrode metal plate and a heat dissipation device-integrated base during a manufacturing process of a heat dissipation device-integrated heat dissipation substrate for a semiconductor in accordance with an embodiment of the present invention.
FIG. 14 illustrates a cross-section of a heat dissipation device-integrated heat dissipation substrate for a semiconductor in accordance with an embodiment of the present invention.
FIG. 15 is a perspective view of a heat dissipation device-integrated heat dissipation substrate for a semiconductor in accordance with an embodiment of FIG. 14.
FIG. 16 is an exploded perspective view of a base in a heat dissipation device-integrated heat dissipation substrate for a semiconductor in accordance with an embodiment of FIG. 14.
FIG. 17 illustrates a cross-section of a heat dissipation device-integrated heat dissipation substrate for a semiconductor in accordance with another embodiment of the present invention.

### Mode for Invention

Hereafter, various embodiments of the present invention will be described with reference to the drawings. The present invention will be more clearly understood through the embodiments. In this specification, directional terms such as upper, lower, top, and bottom are based on directions illustrated in the accompanying drawings unless otherwise specified.

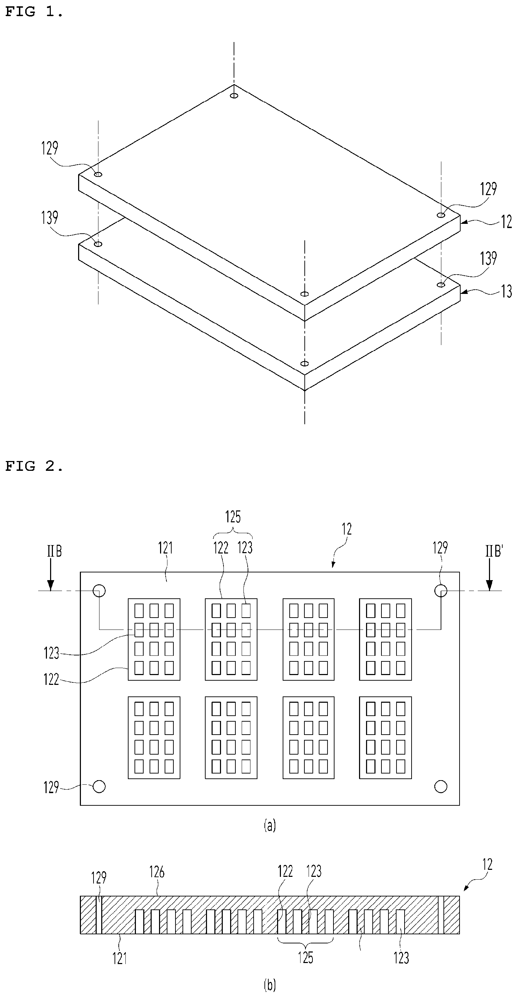

FIG. 1 illustrates a preparation state of first and second base plates during a manufacturing process in accordance with an embodiment of the present invention.

A pair of base plates serving to constitute a heat dissipation device, that is, a first base 12 and a second base 13 are prepared. The first and second bases 12 and 13 are metal plates and may each be made of a material such as aluminum or copper with excellent thermal conductivity and processability but are not limited to those exemplified here. The first and second bases 12 and 13 do not need to have the same thickness, but preferably have the same planar dimensions.

The first and second bases 12 and 13 have alignment marks that match each other at the same position in plan view. The shapes of the alignment marks are not limited, and in accordance with the present embodiment, the shapes may be a plurality of pinholes 129 and 139 formed to penetrate the pair of bases 12 and 13. The pinholes 129 and 139 are inserted into alignment pins (not illustrated) provided separately or in processing equipment so that the planar positions of the first and second bases 12 and 13 are aligned with each other or with respect to the processing equipment. In contrast, various examples such as pins and holes, protrusions and grooves, or vision identification marks that three-dimensionally correspond to each other may be applied as the alignment marks.

FIGS. 2A and 2B illustrate a first base processing state during a manufacturing process in accordance with an embodiment of the present invention. Hereinafter, a first base plate and a second base plate in the processed state are referred to as the first base 12 and the second base 13, respectively.

FIG. 2A is a plan view of a first surface 121 of the first base 12, and FIG. 2B illustrates a cross section taken along line IIB-IIB' in FIG. 2A. The first surface 121 corresponds to an inner surface of two planes of the first base 12, which faces the second base 13. A plurality of first unit parts 125 constituting a part of a plurality of heat dissipation device units are formed on the first surface 121 of the first base 12. In accordance with the present embodiment, as an example of a heat dissipation device unit including a refrigerant flow path, the first unit part 125 may constitute a part of a water jacket.

The first unit part 125 is formed with a unit groove 122 constituting a part of a coolant receiving space of the water jacket and a plurality of cooling fins 123 disposed in each unit groove 122. The structure of the first unit part 125 including the unit groove 122 and the plurality of cooling fins 123 may be processed by leaving the plurality of cooling fins 123 in the process of cutting the unit groove 122 by using a CNC machining machine, for example. However, the processing method is not limited to the present embodiment. In designing and processing the first base 12, the positions of the plurality of first unit parts 125 are determined based on the positions of the above-described plurality of pinholes 129, that is, the alignment marks.

On the other hand, a second surface 126 of the first base 12, which is opposite to the first surface 121, preferably remains flat. This is because an insulating layer and an electrode pattern are to be disposed on the second surface 126.

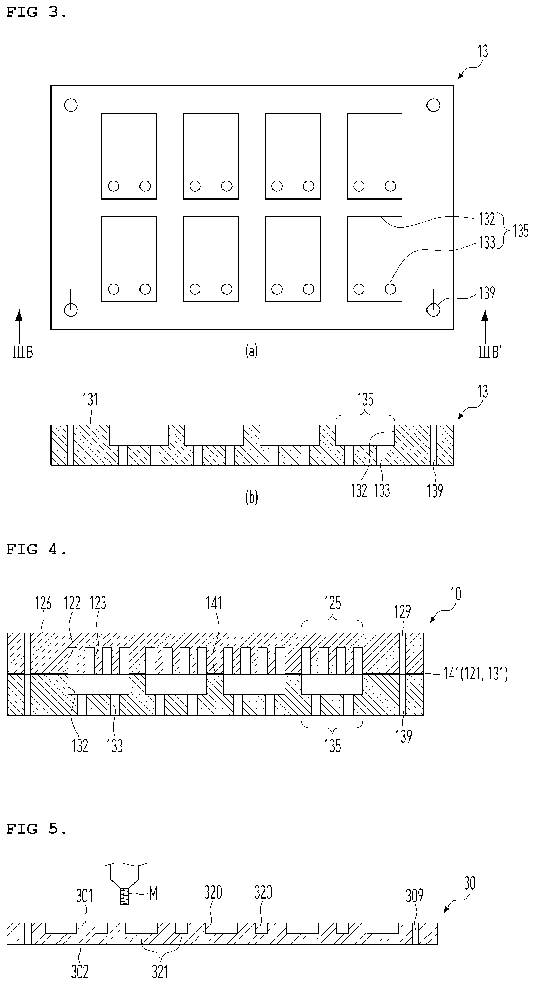

FIGS. 3A and 3B illustrate a second base processing state during a manufacturing process in accordance with an embodiment of the present invention.

FIG. 3A is a plan view of a first surface 131 of the second base 13, and FIG. 3B illustrates a cross section taken along line IIIB-IIIB' in FIG. 3A. The first surface 131 corresponds to an inner surface of two planes of the second base 13, which faces the first base 12. A plurality of second unit parts 135 constituting a part of the plurality of heat dissipation device units are formed on the first surface 131 of the second base 13. In accordance with the present embodiment, the second unit part 135 is an example of a heat dissipation device unit including a refrigerant flow path, and may constitute a water jacket unit together with the above-described first unit part 125 in FIG. 2.

A plurality of unit grooves 132 may be formed in the second base 13 in the form of a concave groove from the first surface 131, the plurality of unit grooves 132 corresponding to the plurality of unit grooves 122 in FIG. 2 described above, respectively. A coolant inlet/outlet 133 through which coolant flows in and out may be formed in each of the plurality of unit grooves 132. The coolant inlet/outlet 133 may be formed in the form of a through hole by penetrating the bottom surface of the unit groove 131 formed by removing a part of the first surface 131 of the second base 13. Also, in designing and processing the second base 13, the positions of the plurality of second unit parts 135 are determined based on the positions of the plurality of pinholes 139, that is, the alignment marks.

Although not illustrated, cooling fins (not illustrated) of the same or similar form as the plurality of cooling fins 123 formed in the plurality of unit grooves 122 of the first base 12 may also be formed in the plurality of unit grooves 132 of the second base 13. Such a cooling fin forming operation may also be performed simultaneously with the forming of the plurality of unit grooves 132.

FIG. 4 illustrates a heat dissipation device-integrated base in which the first base in FIG. 2 and the second base in FIG. 3 are bonded.

A heat dissipation device-integrated base 10 may be formed by placing the first surface 121 of the first base 12 and the first surface 131 of the second base 13 to face each other and bonding the first surfaces 121 and 131. At this time, the pinholes 129 and 139 are aligned with each other to proceed with bonding, so that the plurality of first unit parts 125 of the first base 12 and the plurality of second unit parts 135 of the second base 13 are combined together to form a plurality of water jacket units. A bonding portion 141 between the first surface 121 of the first base 12 and the first surface 131 of the second base 13 is formed by brazing.

The brazing is a method in which only a metal filler material is melted at a temperature of 450°C or more without melting a metal base material, the molten filler material penetrates between the surfaces of the two metal base materials through a capillary phenomenon or the like and then is solidified, so that the two metal base materials are bonded. In accordance with the present invention, a filler material is placed between the first surface 121 of the first base 12 and the first surface 131 of the second base 13 and the two base plates are heated and cooled, thereby forming the bonding portion 141 in which the filler material is melted and re-solidified. The bonding portion 141 formed by the brazing in this way has a lower heat conduction resistance and superior airtightness than other bonding portions/adhesive portions.

In addition, a third member (not illustrated) is added between the first base 12 and the second base 13, and the first and second bases 12 and 13 and the third member are bonded to each other, so that a heat media circulation space formed in the first and second bases 12 and 13 and the third member may be configured to complete the space of the plurality of heat dissipation device units.

FIG. 5 illustrates a processing state of a first side of an electrode metal plate during a manufacturing process in accordance with an embodiment of the present invention.

An electrode metal plate 30 is a metal plate on which one or a plurality of electrode pattern units for a circuit configuration of a high-power semiconductor device module may be arranged, and may further include a pinhole 309 as an alignment mark as illustrated in the drawing. The electrode metal plate 30 may be made of an electrode metal material, for example, copper. Groove patterns 320 corresponding to the plurality of electrode pattern units are formed on a first surface 301 of the electrode metal plate 30. The groove pattern 320 is formed by processing a portion, which corresponds to a pattern space between electrodes, and a portion, which corresponds to a peripheral portion of an electrode group including a plurality of electrodes constituting one circuit, to a predetermined shallower depth than the thickness of the electrode metal plate 30, and remaining portions 321 each having a predetermined thickness are left at the bottom of the groove pattern 320. The processing of forming the groove pattern 320 may be performed using a CNC cutting machine M, for example, or may be performed through laser processing, press processing, or the like.

The design and processing of the plurality of electrode pattern units may also be based on the position of the alignment mark, so that one electrode pattern unit may be disposed for each of the plurality of water jacket units of FIG. 4 described above.

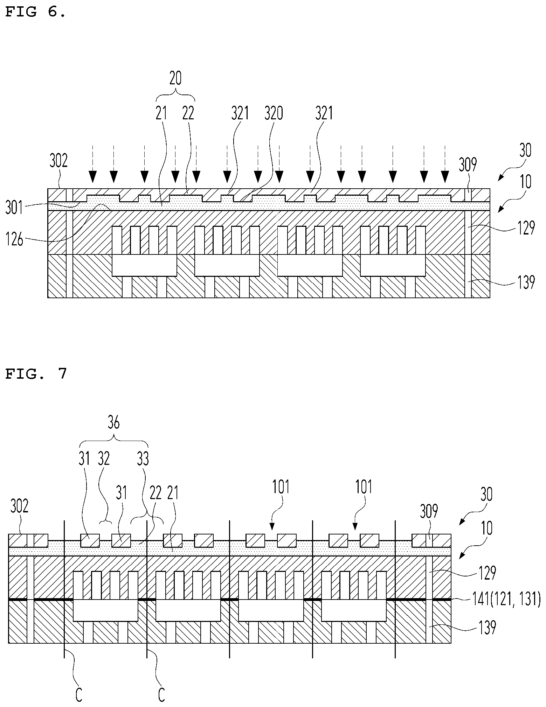

FIG. 6 illustrates a state in which the electrode metal plate in FIG. 5 is bonded to the heat dissipation device-integrated base in FIG. 4.

Subsequently, the electrode metal plate 30 processed as illustrated in FIG. 5 is bonded to the upper surface 126 of the heat dissipation device-integrated base 10 that has been bonded as illustrated in FIG. 4, by using insulating resin. At this time, the first surface 301 of the electrode metal plate 30, which is formed with the groove pattern 320, is bonded to face the upper surface 126 of the heat dissipation device-integrated base 10 via the insulating resin. During the bonding, by matching the pinholes 309 of the electrode metal plate 30 with the pinholes 129 and 139 of the heat dissipation device-integrated base 10, the positions of the two members may be aligned. When the insulating resin is cured, an insulating layer 21 located between the upper surface 126 of the heat dissipation device-integrated base 10 and the electrode region of the electrode metal plate 30 and an insulator charging portion 22 located in the groove pattern 320 are formed.

The bonding of the electrode metal plate 30 and the heat dissipation device-integrated base 10 using insulating resin may include a vacuum hot pressing process, and the process temperature of the vacuum hot pressing process is lower than the process temperature of the brazing bonding process and the heat resistance temperature of the bonding portion 141. Accordingly, as in the present invention,

it is advantageous to first perform the bonding process of the heat dissipation device-integrated base 10 and then bond the electrode metal plate 30 thereon. When the two bonding processes are performed in an opposite order, the insulator may be melted or be damaged by heat during the brazing bonding, causing problems such as deformation of the electrode pattern or insulation breakdown.

Subsequently, as indicated by a plurality of dotted arrows in this drawing, a second surface 302 of the electrode metal plate 30 is deleted entirely, or at least the remaining portion 321 is selectively deleted. In order to remove the remaining portion 321, an etching process or a cutting process may be used. During the etching, an etch mask may be used to selectively delete only the remaining portion 321.

Unlike the above-described embodiment, after completing the heat dissipation device-integrated base 10, a flat electrode metal plate may be bonded to the upper surface of the heat dissipation device-integrated base 10 via insulating resin and then may be processed to form a plurality of electrode pattern units. As in the above-described embodiment, regardless of a method of first forming a plurality of groove pattern units corresponding to a plurality of electrode pattern units on an electrode metal plate, performing bonding, and then deleting a remaining portion, or a method of forming a plurality of electrode pattern units after bonding a flat electrode metal plate, it is possible to complete a plate of a heat dissipation substrate for a semiconductor in which the plurality of electrode pattern units are arranged in a one-to-one correspondence above the plurality of heat dissipation device units formed in the heat dissipation device-integrated base.

FIG. 7 illustrates a state before cutting a plate of a heat dissipation substrate for a semiconductor in accordance with an embodiment of the present invention.

FIG. 7 illustrates a state in which a plurality of electrodes 31, a pattern space 32, and a peripheral portion 33 are formed in each electrode pattern unit 36 after completing the process of deleting the remaining portion 321 in FIG. 6 described above. The electrode pattern units 36 are arranged in a one-to-one correspondence above the plurality of water jacket units provided within the heat dissipation device-integrated base 10. In this state, when cutting is performed by the unit along the cutting line C, a combination of an electrode pattern forming a circuit for a high-power semiconductor device module and a water jacket integrally formed below the electrode pattern, that is, a heat dissipation device (water jacket)-integrated heat dissipation substrate 101 for a semiconductor is provided.

Although the above embodiment of FIGS. 1, 2A, 2B, 3A, 3B, 4, 5, 6, and 7 has described an example suitable for mass production by simultaneously producing a plurality of units having the same standard on one plate, since the processing processes of FIGS. 2A, 2B, 3A, 3B, and 5 are all performed using a design and processing method based on the same alignment mark, the manufacturing method in accordance with the present invention can be used to produce small quantities of various types heat dissipation device-integrated heat dissipation substrates for a semiconductor, which have no same specification.

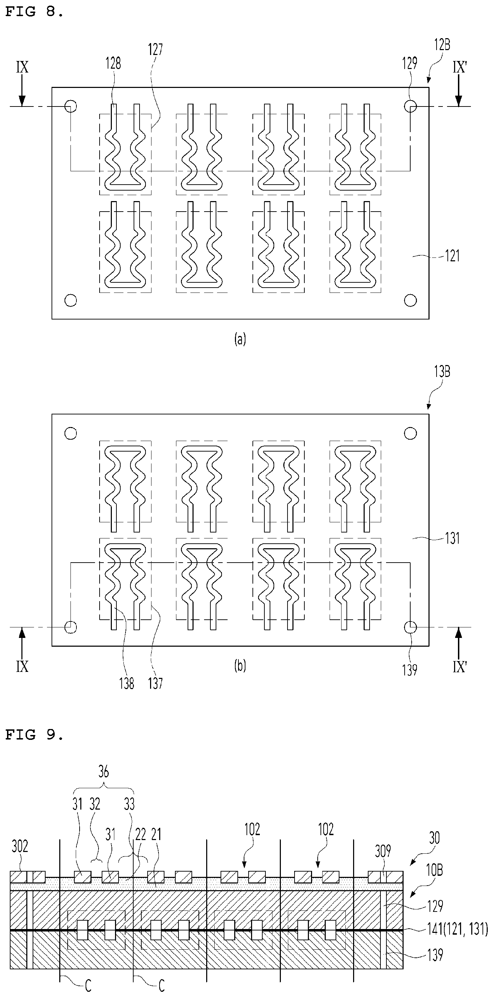

FIGS. 8A and 8B illustrate first and second base processing states during a manufacturing process in accordance with an embodiment of the present invention.

Unlike the embodiment of FIGS. 2A, 2B, 3A, and 3B described above, FIGS. 8A and 8B relate to a manufacturing method of a heat dissipation substrate for a semiconductor in which a heat exchanger having a refrigerant flow path is integrally formed as a heat dissipation device. FIG. 8A is a view of a first base 12B viewed from a first surface 121 being an inner surface, and FIG. 8B is a view of a second base 13B viewed from a first surface 131 being an inner surface. The first and second bases 12B and 13B may be provided with a plurality of pinholes 129 and 139 as alignment marks for alignment when bonded to each other, respectively.

As illustrated in FIGS. 8A and 8B, first unit parts 127 and second unit parts 137 are formed on the first surface 121 of the first base 12B and the first surface 131 of the second base 13B, respectively, to form a plurality of heat dissipation device units. A first flow path groove pattern 128 and a second flow path groove pattern 138 are processed in the first and second unit parts 127 and 137, respectively. The first and second flow path groove patterns 128 and 138 may be processed using a CNC cutting machine, but may also be processed using other methods such as press machining. The first and second flow path groove patterns 128 and 138 are arranged to face each other to form a refrigerant flow path. For example, the first and second flow path groove patterns 128 and 138 may each be formed to have a rectangular cross-section with a predetermined depth, and as needed, the first and second flow path groove patterns 128 and 138 may be modified in various ways, such as having different depths or forming into semicircular cross-sections.

In addition, the heat dissipation device unit that can be formed integrally within the heat dissipation device-integrated base in accordance with the present invention may include various types of heat dissipation devices having a refrigerant flow path (including a flow space) formed between first and second base substrates, such as a heat pipe, in addition to the water jacket or the heat exchanger described above.

FIG. 9 illustrates a state before cutting a plate of a heat dissipation substrate for a semiconductor to which the first and second bases in FIG. 8 are applied.

Although not separately illustrated, subsequent to the process of FIG. 8, the first base 12B provided with the plurality of first unit parts 127 and the second base 13B provided with the plurality of second unit parts 137 are bonded to each other so that the first surfaces 121 and 131 thereof face each other, thereby forming a heat dissipation device-integrated base 10B. Details of the method of bonding the first base 12B and the second base 13B are the same as those described with reference to FIG. 4.

As described with reference to FIGS. 5 and 6, the electrode metal plate 30 is processed and is bonded to the heat dissipation device-integrated base via insulating resin, and then remaining portions on the surface of the electrode metal plate 30 are removed, thereby forming the plurality of electrode pattern units 36 corresponding to the plurality of heat dissipation device units. Through this process, the electrode pattern unit 36 and the heat exchanger unit are combined to form an integrated unit, and the integrated unit is cut along the cutting line C, thereby forming a plurality of heat dissipation device-integrated heat dissipation substrates 102 for a semiconductor.

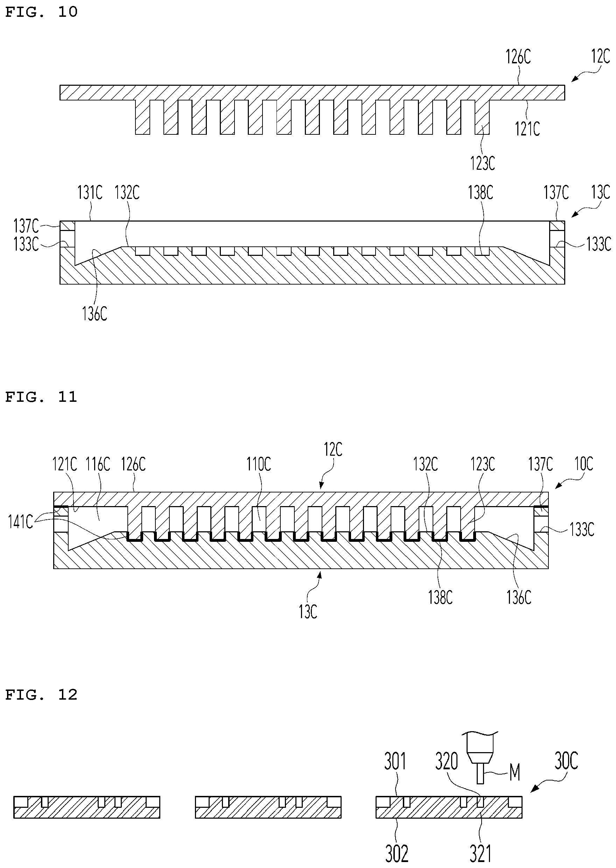

FIG. 10 illustrates a manufacturing process of a heat dissipation device-integrated base during a manufacturing process of a heat dissipation device-integrated heat dissipation substrate for a semiconductor in accordance with an embodiment of the present invention.

A first base 12C, which provides a flat upper surface 126C on which a plurality of electrodes are disposed to be insulated from each other, may be formed by processing a metal plate with a predetermined thickness, that is, a first base plate, as in the above-described embodiments, and a plurality of cooling fins 123C protruding in a direction away from the upper surface 126C may be disposed on an opposite side of the upper surface 126C. The plurality of cooling fins 123C may be formed by cutting a bottom surface 121C of the first base plate. However, the method of forming the plurality of cooling fins 123C is not limited to only the cutting process.

A second base 13C, which forms a heat media circulation space between two opposing inner surfaces together with the first base 12C, may be formed by processing a second base plate in the form of a metal plate or a metal block formed with a groove having a predetermined depth formed on the inner surface. The groove of the second base 13C forms a heat media circulation space, and is formed to have a first bottom surface 132C that is shallow and flat and is disposed at the center of the second base 13C on the inner side facing the first base 12C, and a second bottom surface 136C connected from both ends of the first bottom surface 132C and having a deeper depth than the first bottom surface 132C. The second bottom surface 136C may be formed to gradually become deeper toward both side ends from the portion connected to the first bottom surface 132C. A side wall portion 137C disposed at the end of the second bottom surface 132C connects a space formed between the second bottom surface 136C and the first base 12C to the outside, and is formed with, for example, a coolant inlet/outlet 133C through which coolant may enter and exit.

A plurality of fin grooves 138C corresponding to the plurality of cooling fins 123C of the first base 12C are disposed on the first bottom surface 132C of the second base 13C. The fin groove 138C may be formed to accommodate a part of a distal end of a corresponding one of the cooling fins 123C. The plurality of cooling fins 123C may each be formed in the form of a cylinder, an elliptical pillar, a square pillar, a hexagonal pillar, or the like, and the fin groove 138C may have a shape corresponding to the shape of the cooling fin 123C, such as a circle, an oval, a square, or a hexagon, and may be formed to have a predetermined depth shorter than the length of the cooling fin 123C.

The second base 13C may be formed of an aluminum or aluminum alloy block in consideration of a volume according to depths of the first and second bottom surfaces 132C and 136C. In this case, at least a part of structures such as the first and second bottom surfaces 132C and 136C and the plurality of fin grooves 138C may be formed by die casting. The first and second bottom surfaces 132C and 136C, the side wall portion 137C, and the like may be formed by die casting, and the plurality of fin grooves 138C requiring precision may be formed through a cutting process.

FIG. 11 illustrates an assembled state of a heat dissipation device-integrated base during a manufacturing process of a heat dissipation device-integrated heat dissipation substrate for a semiconductor in accordance with an embodiment of the present invention.

A heat dissipation device-integrated base 10C in accordance with the present embodiment may be formed by coupling two opposing inner surfaces of a first base 12C and a second base 13C.

The first base 12C and the second base 13C are bonded to each other by brazing. A brazing bonding portion 141C may be formed between a side wall portion 137C forming an edge of the second base 13C and a bottom surface of the first base 12C. At this time, the distal ends of the plurality of cooling fins 123C are inserted into the plurality of fin grooves 138C, and a brazing bonding portion may also be formed at a contact portion between the distal ends of the plurality of cooling fins 123C and the plurality of fin grooves 138C.

Such a structure is advantageous in strengthening the coupling force between the first base 12C and the second base 13C, and maintaining coupling between the first base 12C and the second base 13C even though there is a difference in the degree of thermal expansion due to a difference in temperatures and/or linear expansion coefficient of the first base 12C and the second base 13C. In addition, since the plurality of cooling fins 123C are inserted into the plurality of fin grooves 138C and are supported even in the transverse direction, thermal expansion deformation in the transverse direction of the first base 12C, that is, in the direction parallel to the upper surface, can be suppressed.

A heat media circulation space formed between the first base 12C and the second base 13C is divided into a main cooling portion 110C with a relatively narrow spacing by the first bottom surface 132C and an inlet/outlet portion 116C with a relatively wide spacing by the second bottom surface 136C in terms of a spacing between the inner surface of the first base 12C and the inner surface of the second base 13C. In the portion 110C where the spacing is relatively narrow, the flow rate of refrigerant, such as coolant, increases. Such a structure allows coolant to pass between the plurality of cooling fins 123C at high speed, thereby improving cooling efficiency.

FIG. 12 illustrates an electrode metal plate preparation step during a manufacturing process of a heat dissipation device-integrated heat dissipation substrate for a semiconductor in accordance with an embodiment of the present invention.

An electrode metal plate 30C is prepared regardless of the process and sequence illustrated in FIGS. 10 and 11. Like the above-described embodiment of FIG. 5, a groove pattern 320 corresponding to a circuit pattern including a plurality of electrodes is formed on a first surface 301 of the electrode metal plate 30C. The groove pattern 320 is formed by processing a portion corresponding to a pattern space between electrodes to have a predetermined depth shallower than the thickness of the electrode metal plate 30, and a remaining portion 321 with a predetermined depth is left at the bottom of the groove pattern 320. The processing of forming the groove pattern 320 may be performed using a CNC cutting machine M, for example, or may be performed through laser processing, press processing, or the like.

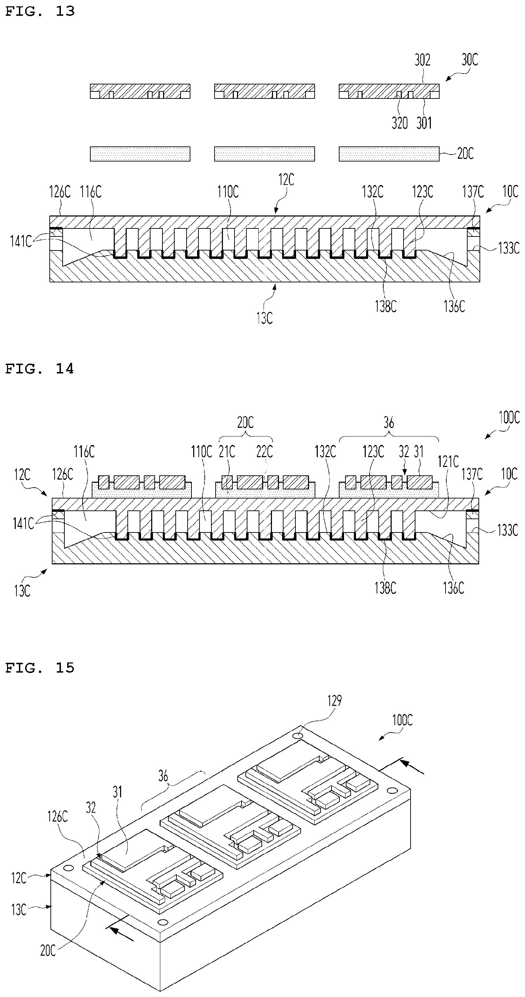

The preparation step of the electrode metal plate 30C in accordance with the present embodiment is different from the above-described embodiment of FIG. 5 in that one or more electrode metal plates 30C correspond to heat dissipation device-integrated base assembly. When a plurality of electrode metal plates 30C are employed, a circuit pattern constituting one circuit unit may be formed on each of the plurality of electrode metal plates 30C. For example, when a three-phase inverter module is formed on heat dissipation device-integrated base 10C (see FIG. 14 or 15), a circuit pattern constituting three inverter circuit units may be implemented by providing one unit to each of three electrode metal plates 30C. To this end, in this step, groove patterns 320 corresponding to the circuit pattern may be formed on the three electrode metal plates 30C.

FIG. 13 illustrates a bonding step of an electrode metal plate and a heat dissipation device-integrated base during a manufacturing process of a heat dissipation device-integrated heat dissipation substrate for a semiconductor in accordance with an embodiment of the present invention.

In this step, one or more electrode metal plates 30C formed with the groove patterns 320 formed through the step of FIG. 12 are bonded to the upper surface of the heat dissipation device-integrated base 10C via an insulator portion 20C. The insulator portion 20C is insulating resin as described with reference to FIG. 6, and may be applied to the first surface 301 of the electrode metal plate 30C, which is formed with the groove patterns 320, or the upper surface of the heat dissipation device-integrated base 10C. The insulator portion 20C may be provided in the form of a semi-cured insulating resin sheet. Such a semi-cured insulating resin sheet may include a ceramic mesh therein.

As a method of curing the insulator portion 20C so that the one or more electrode metal plates 30C may be bonded to the heat dissipation device-integrated base 10C via the insulator portion 20C, a vacuum hot press process may be applied as described above. The vacuum hot press process is performed at a temperature significantly lower than the melting point of the brazing bonding portion 141C that bonds the first and second bases 12C and 13C of the heat dissipation device-integrated base 10C.

FIG. 14 illustrates a cross-section of a heat dissipation device-integrated heat dissipation substrate for a semiconductor in accordance with an embodiment of the present invention.

After going through the above-described bonding step of FIG. 13, as described with reference to FIG. 6, when the remaining portion 321 (see FIG. 12) is deleted from the electrode metal plate 30C, a heat dissipation device-integrated heat dissipation substrate 100C for a semiconductor, in which one or more circuit units 36 are bonded to the upper surface of the heat dissipation device-integrated base 10C as illustrated in FIG. 14 via the insulator portion 20C and integrated with the heat dissipation device-integrated base 10C, may be completed. The process of removing the remaining portion 321 may include cutting and/or etching.

When the bonding is performed through the same process as described with reference to FIG. 13, a part of the insulator portion 20C forms an insulating layer 21C with a predetermined thickness between the electrode metal plate 30C and the heat dissipation device-integrated base 10C, and the other part fills the groove pattern 320. As a result, the insulating resin filling the groove pattern 320 forms an insulator charging portion 22C that supports a part of the side surfaces of the plurality of electrodes 31 in the pattern space 32 between the plurality of electrodes 31.

Unlike the description in the process of FIGS. 13 and 14, the electrode metal plate 30C formed with the groove patterns 320 may be disposed so that the second surface 302 (see FIG. 13) opposite to the first surface 301 formed with the groove patterns 320 faces the upper surface of the heat dissipation device-integrated base 10C, so that the electrode metal plate 30C may be bonded via the insulator portion 20C. In this case, the plurality of electrodes 31 may be formed in the form of an island floating on the insulator portion 20C. In this case, the shape is different from that in the embodiment of FIG. 14 in which the plurality of electrodes 31 are partially embedded in the insulator portion 20C. However, in terms of the strength of the plurality of electrodes 31 from falling off, the arrangement in the embodiment of FIG. 14 is more advantageous.

FIG. 15 is a perspective view of a heat dissipation device-integrated heat dissipation substrate for a semiconductor in accordance with an embodiment of FIG. 14.

FIG. 15 is a perspective view of a heat dissipation device-integrated heat dissipation substrate for a semiconductor in accordance with an embodiment of FIG. 14.

FIG. 15 is a view of the heat dissipation device-integrated heat dissipation substrate 100C for a semiconductor in accordance with the present embodiment, viewed obliquely from above. One or more circuit units 36 may be disposed on the upper surface 126C of the first base 12C. For example, as described above with reference to FIGS. 12 to 14, three inverter circuit units constituting a three-phase inverter module may be disposed on heat dissipation device-integrated base.

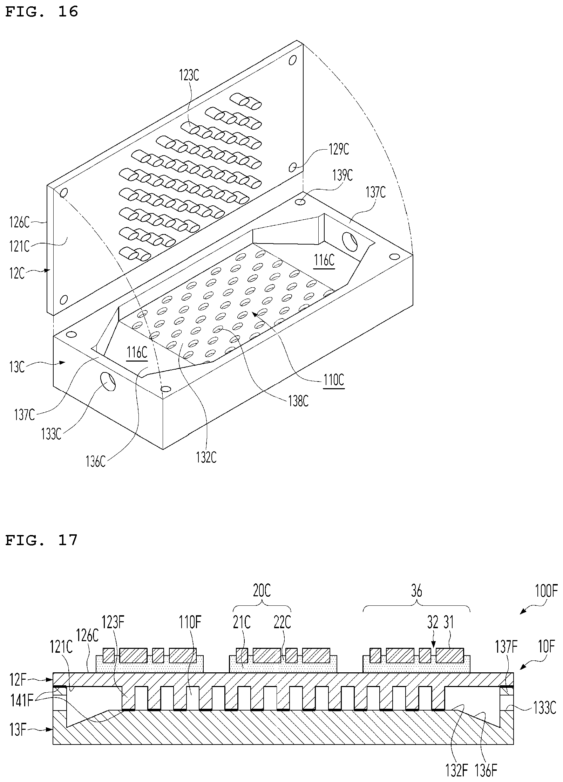

FIG. 16 is an exploded perspective view of a base in a heat dissipation device-integrated heat dissipation substrate for a semiconductor in accordance with an embodiment of FIG. 14.

In order to facilitate understanding of the heat dissipation device-integrated heat dissipation substrate for a semiconductor in accordance with the embodiment of FIG. 14, FIG. 16 illustrates that the first base 12C and the second base 13C of the heat dissipation device-integrated base are not bonded to each other and open. As described above, the plurality of cooling fins 123C are disposed on the bottom surface 121C of the first base 12C to protrude from the bottom surface 121C.

The plurality of cooling fins 123C may each be formed, for example, in the shape of an elliptical pillar. The plurality of fin grooves 138C are also formed in a shape corresponding to the plurality of cooling fins 123C. The heat media circulation space formed in the shape of a concave groove surrounded by the side wall portion 137C in the second base 13C is formed by a shallow and flat first bottom surface 132C together with the bottom surface 121C of the first base 12C and a second bottom surface 136C connected to both ends of the first bottom surface 132C and becoming deeper outward. The coolant inlets/outlets 133C are provided on the side wall portions 137C at both ends close to the second bottom surface 136C, the inside of the coolant inlets/outlet 133C forms the inlet/outlet portion 116C, and a shallow space formed by the first bottom surface 132C forms the main cooling unit 110C. As the inlet/outlet portion 116C moves from the coolant inlet/outlet 133C toward the main cooling portion 110C, the depth becomes shallower while the width gradually becomes wider, thereby allowing coolant to contact a greater number of cooling fins 123C in the main cooling portion 110C.

The plurality of cooling fins 123C may be formed to have an elongated elliptical cross section in the longitudinal direction in which the inlet/outlet portions 116C on both sides of the main cooling portion 110C are connected. This shape of the cooling fins assists in reducing resistance to coolant flow. Although the present invention is not limited to such an embodiment, the crosssectional shape of the plurality of cooling fins 123C is preferably formed so that coolant may flow smoothly in a laminar flow like a diamond whose width in the longitudinal direction is narrower than the width in a direction perpendicular to the longitudinal direction.

On the other hand, the first base 12C and the second base 13C are provided with the plurality of pinholes 129C and 139C, respectively, and these members may be aligned while a process is being performed using the plurality of pinholes 129C and 139C. The plurality of pinholes 129C and 139C may also be used as screw holes for fastening the first base 12C to the second base 13C.

FIG. 17 illustrates a cross-section of a heat dissipation device-integrated heat dissipation substrate for a semiconductor in accordance with another embodiment of the present invention.

A heat dissipation device-integrated heat dissipation substrate 100F for a semiconductor in accordance with the present embodiment is different from the heat dissipation device-integrated heat dissipation substrate 100C for a semiconductor in accordance with the embodiment of FIG. 14 in that a first bottom surface 132F of a second base 13F is formed with no fin grooves corresponding to a plurality of cooling fins 123F and is flat. The depth of the first bottom surface 132F with respect to an upper end of a side wall portion 137F may match the length of the plurality of cooling fins 123F with respect to an inner surface of the first base 12F, and distal ends of the plurality of cooling fins 123F is bonded to the second bottom surface 132F through a brazing bonding portion 141F. Through such a structure, heat conduction efficiency between the first base 12F and a second base 13F can be increased and structural stability can be improved.

## Claims

1. A manufacturing method of a heat dissipation device-integrated heat dissipation substrate for a semiconductor, the heat dissipation substrate used to mount a semiconductor device and comprising a plurality of electrodes (31) separated from each other by a pattern space (32) and electrically insulated from each other, a metal base integrated with a heat media circulation space for absorbing and dissipating heat transferred from the plurality of electrodes (31), and an insulating layer (21) made of insulating resin and bonding the plurality of electrodes (31) to the metal base, the manufacturing method comprising:
a base processing step of preparing a first base plate and a second base plate in the form of metal plates that overlap each other and constitute at least a part of the metal base, and providing a first base (12) and a second base (13) in which a three-dimensional structure forming the heat media circulation space is formed on an inner surface of at least one of the first base plate and the second base plate;
a base coupling step of coupling opposing inner surfaces of the first base (12) and the second base (13) against each other to form a heat dissipation device-integrated base (10) including the heat media circulation space, wherein the first base (12) and the second base (13) are bonded to each other through a brazing process, and wherein, in the brazing process of the base coupling step, a filler material is placed between a surface (121) of the first base (12) and a surface (131) of the second base (13), and the two base plates (12, 13) are heated and cooled, thereby forming the bonding portion (141) in which the filler material is melted and re-solidified; and
an electrode processing step including either:
an electrode metal plate preparation step of processing an electrode metal plate (30) to form a groove pattern (320) corresponding to the pattern space (32), the electrode metal plate (30) being a metal plate material serving to constitute the plurality of electrodes (31), and preparing the electrode metal plate (30) configured to cover an area corresponding to at least one circuit unit by a remaining portion (321) left when the groove pattern (320) is formed, without generating an opening and an electrode metal plate bonding step of bonding, which is subsequently performed after the base coupling step, via insulating resin, the electrode metal plate (30) to an upper surface (126) of the heat dissipation device-integrated base (10) formed in the base coupling step; or
a flat plate bonding step of bonding the electrode metal plate (30) in the form of a flat plate to the upper surface of the heat dissipation device-integrated base (10) via insulating resin and an electrode forming step of forming the plurality of electrodes (31) on the electrode metal plate (30) by deleting a pattern corresponding to the pattern space (32),
wherein, the process temperature of the electrode metal plate bonding step is lower than the process temperature of the base coupling step.

2. The manufacturing method of claim 1, wherein, in the electrode metal plate bonding step, an insulating layer (21) is formed between a first surface (301) of the electrode metal plate (30) formed with the groove pattern (320) and an upper surface (126) of the heat dissipation device-integrated base (10), and bonding is performed so that the groove pattern (320) is filled with an insulator.

3. The manufacturing method of claim 2, wherein, in the electrode metal plate bonding step, the insulating layer (21) is formed using a semi-cured insulating resin sheet.

4. The manufacturing method of claim 2 or 3, wherein, when an electrode metal plate preparation step is performed, the method further comprises:
an electrode forming step of separating the plurality of electrodes (31) from each other by deleting the remaining portion (321) from an upper surface (126) of the electrode metal plate (30) after the electrode metal plate bonding step.

5. The manufacturing method of any one of claims 1 to 4, wherein, in the base processing step and the base coupling step, a plurality of heat dissipation device units each including the heat media circulation space formed between two opposing inner surfaces of the first and second bases (12, 13) and selected from a group including a water jacket, a heat exchanger, and a heat pipe are integrally formed by processing the first and second bases (12, 13) and coupling the first and second bases (12, 13).

6. The manufacturing method of claim 5, wherein, in the base processing step, the first and second bases (12, 13) are processed so that the plurality of heat dissipation device units are arranged in a planar manner within the heat dissipation device-integrated base (10).

7. The manufacturing method of claim 6, wherein, in the electrode metal plate preparation step, disposing a plurality of groove pattern units, each constituting one circuit and corresponding to each of the plurality of heat dissipation device units, and
further comprising:
a cutting step of cutting a plate which is formed by the electrode metal plate bonding step bonding the electrode metal plate (30) and the heat dissipation device-integrated base (10) with the insulating resin, to form a plurality of heat dissipation device-integrated heat dissipation substrate units for a semiconductor.

8. The manufacturing method of any one of claims 5 to 7, wherein, in the base processing step, the first and second bases (12, 13) are processed so that the one heat dissipation device unit is configured in the heat dissipation device-integrated base (10), and
in the electrode metal plate preparation step and the electrode metal plate bonding step, a plurality of electrode metal plates (30) each formed with a groove pattern (320) corresponding to one circuit unit are prepared and bonded to the upper surface (126) of the heat dissipation device-integrated base (10).

9. The manufacturing method of any one of claims 1 to 8,
wherein, in the base processing step, a plurality of cooling fins (123C) are formed protruding from a bottom surface of the first base (12C), and
in the base coupling step, distal ends of the plurality of cooling fins (123C) are coupled to a bottom surface of a three-dimensional structure forming the heat media circulation space of the second base (13C) to be fixedly supported at least in a transverse direction parallel to a plane to which the second base (13C) belongs.

10. The manufacturing method of claim 9, wherein, in the base processing step, a plurality of fin grooves (138C) are formed on the bottom surface to accommodate the distal ends of the plurality of cooling fins (123C), and
in the base coupling step, the first and second bases (12C, 13C) are coupled to each other in a state in which the distal ends of the plurality of cooling fins (123C) are inserted into the plurality of fin grooves (138C), respectively.

11. The manufacturing method of claim 9 or 10, wherein, in the base coupling step, inner surfaces of each of the first and second bases (12C, 13C) are brazed to each other, and the distal ends of the plurality of cooling fins (123C) are brazed to the bottom surface.

## Patentansprüche

1. Herstellungsverfahren eines Wärmeableitungsvorrichtung-integrierten Wärmeableitungssubstrats für einen Halbleiter, wobei das Wärmeableitungssubstrat verwendet wird zur Anbringung einer Halbleitervorrichtung und eine Vielzahl von Elektroden (31), die durch einen Musterraum (32) voneinander getrennt und elektrisch voneinander isoliert sind, eine Metallbasis, die mit einem Wärmemediumzirkulationsraum zum Absorbieren und Ableiten von Wärme, die von der Vielzahl von Elektroden (31) übertragen wird, integriert ist, und eine Isolierschicht (21), die aus isolierendem Harz gebildet ist und die Vielzahl von Elektroden (31) mit der Metallbasis verbindet, umfasst, wobei das Herstellungsverfahren umfasst:
einen Basisverarbeitungsschritt zum Erstellen einer ersten Basisplatte und einer zweiten Basisplatte in der Form von Metallplatten, die einander überlappen und zumindest einen Teil der Metallbasis bilden, und Bereitstellens einer ersten Basis (12) und einer zweiten Basis (13), in denen eine dreidimensionale Struktur, die den Wärmemediumzirkulationsraum bildet, auf einer Innenfläche von zumindest einer der ersten Basisplatte und der zweiten Basisplatte gebildet ist;
einen Basiskopplungsschritt zum Koppeln gegenüberliegender Innenflächen der ersten Basis (12) und der zweiten Basis (13) aneinander, um eine Wärmeableitungsvorrichtung-integrierte Basis (10) zu bilden, die den Wärmemediumzirkulationsraum enthält, wobei die erste Basis (12) und die zweite Basis (13) durch einen Lötprozess miteinander verbunden sind, und wobei in dem Lötprozess des Basiskopplungsschritts ein Füllmaterial zwischen einer Oberfläche (121) der ersten Basis (12) und einer Oberfläche (131) der zweiten Basis (13) platziert wird, und die zwei Basisplatten (12, 13) erwärmt und gekühlt werden, wodurch der Verbindungsabschnitt (141) gebildet wird, in dem das Füllmaterial geschmolzen und wieder verfestigt wird; und
einen Elektrodenverarbeitungsschritt, der entweder enthält:
einen Elektrodenmetallplatten-Erstellungsschritt zum Verarbeiten einer Elektrodenmetallplatte (30), um ein Rillenmuster (320) zu bilden, das dem Musterraum (32) entspricht, wobei die Elektrodenmetallplatte (30) ein Metallplattenmaterial ist, das dazu dient, die Vielzahl von Elektroden (31) zu bilden, und Erstellen der Elektrodenmetallplatte (30), die konfiguriert ist, um einen Bereich, der zumindest einer Schaltungseinheit entspricht, durch einen verbleibenden Abschnitt (321), der übrig ist, wenn das Rillenmuster (320) gebildet ist, abzudecken, ohne eine Öffnung zu erzeugen, und einen Elektrodenmetallplatten-Verbindungsschritt zum Verbinden, der anschließend nach dem Basiskopplungsschritt durchgeführt wird, über isolierendes Harz, der Elektrodenmetallplatte (30) mit einer oberen Oberfläche (126) der Wärmeableitungsvorrichtung-integrierten Basis (10), die in dem Basiskopplungsschritt gebildet ist; oder
einen Flachplatten-Verbindungsschritt zum Verbinden der Elektrodenmetallplatte (30) in der Form einer flachen Platte mit der oberen Oberfläche der Wärmeableitungsvorrichtung-integrierten Basis (10) über isolierendes Harz und einen Elektrodenbildungsschritt zum Bilden der Vielzahl von Elektroden (31) auf der Elektrodenmetallplatte (30) durch Löschen eines Musters, das dem Musterraum (32) entspricht,
wobei die Prozesstemperatur des Elektrodenmetallplatten-Verbindungsschritts niedriger als die Prozesstemperatur des Basiskopplungsschritts ist.

2. Herstellungsverfahren nach Anspruch 1, wobei in dem Elektrodenmetallplatten-Verbindungsschritt eine Isolierschicht (21) zwischen einer ersten Oberfläche (301) der Elektrodenmetallplatte (30), die mit dem Rillenmuster (320) gebildet ist, und einer oberen Oberfläche (126) der Wärmeableitungsvorrichtung-integrierten Basis (10) gebildet wird und das Verbinden so durchgeführt wird, dass das Rillenmuster (320) mit einem Isolator gefüllt wird.

3. Herstellungsverfahren nach Anspruch 2, wobei in dem Elektrodenmetallplatten-Verbindungsschritt die Isolierschicht (21) unter Verwendung einer halbgehärteten isolierenden Harzfolie gebildet wird.

4. Herstellungsverfahren nach Anspruch 2 oder 3, wobei, wenn ein Elektrodenmetallplatten-Erstellungsschritt durchgeführt wird, das Verfahren ferner umfasst:
einen Elektrodenbildungsschritt zum Trennen der Vielzahl von Elektroden (31) von jedem anderen Abschnitt durch Löschen des verbleibenden Abschnitts (321) von einer oberen Oberflächenplatte (30) nach der Elektrodenmetallplatte (30) nach dem Elektrodenmetallplatten-Verbindungsschritt.

5. Herstellungsverfahren nach einem der Ansprüche 1 bis 4, wobei in dem Basisverarbeitungsschritt und dem Basiskopplungsschritt eine Vielzahl von Wärmeableitungsvorrichtungseinheiten, die jeweils den Wärmemediumzirkulationsraum enthalten, der zwischen zwei gegenüberliegenden inneren Oberflächen der ersten und zweiten Basis (12, 13) gebildet ist und aus einer Gruppe ausgewählt ist, die einen Wassermantel, einen Wärmetauscher und ein Wärmerohr enthält, durch Verarbeiten der ersten und zweiten Basis (12, 13) und Koppeln der ersten und zweiten Basis (12, 13) integral gebildet werden.

6. Herstellungsverfahren nach Anspruch 5, wobei in dem Basisverarbeitungsschritt die erste und zweite Basis (12, 13) so verarbeitet werden, dass die Vielzahl von Wärmeableitungsvorrichtungseinheiten in einer planaren Weise innerhalb der Wärmeableitungsvorrichtungs-integrierten Basis (10) angeordnet sind.

7. Herstellungsverfahren nach Anspruch 6, wobei in dem Elektrodenmetallplatten-Erstellungsschritt eine Vielzahl von Rillenmustereinheiten angeordnet wird, die jeweils eine Schaltung bilden und jeder der Vielzahl von Wärmeableitungsvorrichtungseinheiten entsprechen, und
ferner umfassend:
einen Schneideschritt zum Schneiden einer Platte, die durch den Elektrodenmetallplatten-Verbindungsschritt gebildet wird, der die Elektrodenmetallplatte (30) und die Wärmeableitungsvorrichtungsintegrierte Basis (10) mit dem isolierenden Harz verbindet, um eine Vielzahl von Wärmeableitungsvorrichtungs-integrierten Wärmeableitungssubstrateinheiten für einen Halbleiter zu bilden.

8. Herstellungsverfahren nach einem der Ansprüche 5 bis 7,
wobei in dem Basisverarbeitungsschritt die erste und zweite Basis (12, 13) so verarbeitet werden, dass die eine Wärmeableitungsvorrichtungseinheit in der Wärmeableitungsvorrichtungs-integrierten Basis (10) konfiguriert ist, und
in dem Elektrodenmetallplatten-Erstellungsschritt und dem Elektrodenmetallplatten-Verbindungsschritt eine Vielzahl von Elektrodenmetallplatten (30), die jeweils mit einem Rillenmuster (320) gebildet sind, das einer Schaltungseinheit entspricht, erstellt und mit der oberen Oberfläche (126) der Wärmeableitungsvorrichtungs-integrierten Basis (10) verbunden werden.

9. Herstellungsverfahren nach einem der Ansprüche 1 bis 8, wobei in dem Basisverarbeitungsschritt eine Vielzahl von Kühlrippen (123C) gebildet werden, die von einer unteren Oberfläche der ersten Basis (12C) vorstehen, und
in dem Basiskopplungsschritt distale Enden der Vielzahl von Kühlrippen (123C) mit einer unteren Oberfläche einer dreidimensionalen Struktur gekoppelt werden, die den Wärmemediumzirkulationsraum der zweiten Basis (13C) bildet, um zumindest in einer Querrichtung parallel zu einer Ebene, zu der die zweite Basis (13C) gehört, fest gestützt zu werden.

10. Herstellungsverfahren nach Anspruch 9, wobei in dem Basisverarbeitungsschritt eine Vielzahl von Rippenrillen (138C) auf der unteren Oberfläche gebildet werden, um die distalen Enden der Vielzahl von Kühlrippen (123C) aufzunehmen, und
in dem Basiskopplungsschritt die erste und die zweite Basis (12C, 13C) in einem Zustand miteinander gekoppelt werden, in dem die distalen Enden der Vielzahl von Kühlrippen (123C) jeweils in die Vielzahl von Rippenrillen (138C) eingesetzt sind.

11. Herstellungsverfahren nach Anspruch 9 oder 10, wobei in dem Basiskopplungsschritt innere Oberflächen von jeder der ersten und der zweiten Basis (12C, 13C) miteinander verlötet werden und die distalen Enden der Vielzahl von Kühlrippen (123C) mit der unteren Oberfläche verlötet werden.

## Revendications

1. Procédé de fabrication d'un substrat de dissipation thermique à dispositif de dissipation thermique intégré pour semi-conducteur, ledit substrat de dissipation thermique étant utilisé pour monter un dispositif semi-conducteur et comprenant une pluralité d'électrodes (31) séparées les unes des autres par un espace de motif (32) et électriquement isolées l'une de l'autre, une base métallique intégrée avec un espace de circulation de milieu caloporteur pour absorber et dissiper la chaleur transférée depuis la pluralité d'électrodes (31), et une couche isolante (21) faite d'une résine isolante et liant la pluralité d'électrodes (31) à la base métallique, ledit procédé de fabrication comprenant :
une étape de traitement de base consistant à préparer une première plaque de base et une deuxième plaque de base sous forme de plaques métalliques qui se recouvrent l'une l'autre et constituent au moins une partie de la base métallique, et à préparer une première base (12) et une deuxième base (13) où une structure tridimensionnelle formant l'espace de circulation de milieu caloporteur est formée sur une surface intérieure de la première et/ou de la deuxième plaques de base ;
une étape de connexion de base consistant à raccorder l'une contre l'autre des surfaces intérieures opposées de la première base (12) et de la deuxième base (13) pour former une base intégrée au dispositif de dissipation thermique (10) comprenant l'espace de circulation de milieu caloporteur, où la première base (12) et la deuxième base (13) sont liées l'une à l'autre au moyen d'un procédé de brasage, et où, lors du procédé de brasage de l'étape de connexion de base, un matériau d'apport est placé entre une surface (121) de la première base (12) et une surface (131) de la deuxième base (13), et les deux plaques de base (12, 13) sont chauffées et refroidies, formant ainsi la partie de liaison (141) où le matériau de remplissage est fondu et resolidifié ; et
une étape de traitement d'électrode comprenant soit :
une étape de préparation de plaque métallique d'électrode consistant à traiter une plaque métallique d'électrode (30) pour former un motif de rainure (320) correspondant à l'espace de motif (32), ladite plaque métallique d'électrode (30) étant un matériau de plaque métallique servant à constituer la pluralité d'électrodes (31), et à préparer la plaque métallique d'électrode (30) prévue pour couvrir une zone correspondant à au moins une unité de circuit par une partie restante (321) laissée lorsque le motif de rainure (320) est formé, sans générer d'ouverture, et une étape de liaison de plaque métallique d'électrode, exécutée consécutivement à l'étape de connexion de base, consistant à lier, au moyen d'une résine isolante, la plaque métallique d'électrode (30) jusqu'à une surface supérieure (126) de la base intégrée au dispositif de dissipation thermique (10) formée lors de l'étape de connexion de base ; soit
une étape de liaison de plaque plate consistant à lier la plaque métallique d'électrode (30) sous forme de plaque plate à la surface supérieure de la base intégrée au dispositif de dissipation thermique (10) au moyen d'une résine isolante et une étape de formation d'électrodes consistant à former la pluralité d'électrodes (31) sur la plaque métallique d'électrode (30) en supprimant un motif correspondant à l'espace de motif (32), où la température de traitement de l'étape de liaison de plaque métallique d'électrode est inférieure à la température de traitement de l'étape de connexion de base.

2. Procédé de fabrication selon la revendication 1, où, lors de l'étape de liaison de plaque métallique d'électrode, une couche isolante (21) est formée entre une première surface (301) de la plaque métallique d'électrode (30) formée avec le motif de rainure (320) et une surface supérieure (126) de la base intégrée au dispositif de dissipation thermique (10), et une liaison est réalisée de sorte que le motif de rainure (320) est comblé avec un isolant.

3. Procédé de fabrication selon la revendication 2, où, lors de l'étape de liaison de plaque métallique d'électrode, la couche isolante (21) est formée au moyen d'une feuille de résine isolante semi-durcie.

4. Procédé de fabrication selon la revendication 2 ou la revendication 3, où, lorsqu'une étape de préparation d'une plaque métallique d'électrode est réalisée, ledit procédé comprend en outre :
une étape de formation d'électrodes consistant à séparer la pluralité d'électrodes (31) les unes des autres en supprimant la partie restante (321) d'une surface supérieure (126) de la plaque métallique d'électrode (30) après l'étape de liaison de plaque métallique d'électrode.

5. Procédé de fabrication selon l'une des revendications 1 à 4, où, lors de l'étape de traitement de base et de l'étape de connexion de base, une pluralité d'unités de dispositif de dissipation thermique comprenant chacune l'espace de circulation de milieu caloporteur formé entre deux surfaces intérieures opposées de la première et de la deuxième bases (12, 13) et sélectionné dans un groupe comprenant une chemise d'eau, un échangeur de chaleur et un caloduc sont formées d'une seule pièce par traitement de la première et de la deuxième bases (12, 13) et raccordement de la première et de la deuxième bases (12, 13).

6. Procédé de fabrication selon la revendication 5, où, lors de l'étape de traitement de base, la première et la deuxième bases (12, 13) sont traitées de manière à prévoir la pluralité d'unités de dispositif de dissipation thermique en planéité à l'intérieur de la base intégrée au dispositif de dissipation thermique (10).

7. Procédé de fabrication selon la revendication 6, où, lors de l'étape de préparation de la plaque métallique d'électrode, est disposée une pluralité d'unités de motif de rainure, constituant chacune un circuit et correspondant à chaque unité de la pluralité d'unités de dispositif de dissipation thermique, et
ledit procédé comprenant en outre :
une étape de découpe consistant à découper une plaque formée par l'étape de liaison de plaque métallique d'électrode consistant à lier la plaque métallique d'électrode (30) et la base intégrée au dispositif de dissipation thermique (10) avec la résine isolante, pour former une pluralité d'unités de substrat de dissipation thermique à dispositif de dissipation thermique intégré pour semi-conducteur.

8. Procédé de fabrication selon l'une des revendications 5 à 7, où, lors de l'étape de traitement de base, la première et la deuxième bases (12, 13) sont traitées de sorte que l'unité de dispositif de dissipation thermique est prévue dans la base intégrée au dispositif de dissipation thermique (10), et où, lors de l'étape de préparation de plaque métallique d'électrode et de l'étape de liaison de plaque métallique d'électrode, une pluralité de plaques métalliques d'électrode (30) formées chacune avec un motif de rainure (320) correspondant à une unité de circuit sont préparées et liées à la surface supérieure (126) de la base intégrée au dispositif de dissipation thermique (10).

9. Procédé de fabrication selon l'une des revendications 1 à 8, où, lors de l'étape de traitement de base, une pluralité d'ailettes de refroidissement (123C) sont formées en saillie sur une surface inférieure de la première base (12C), et,
lors de l'étape de connexion de base, des extrémités distales de la pluralité d'ailettes de refroidissement (123C) sont raccordées à une surface inférieure d'une structure tridimensionnelle formant l'espace de circulation de milieu caloporteur de la deuxième base (13C) de manière à être supportées fixement au moins dans une direction transversale parallèle à un plan dont fait partie la deuxième base (13C).

10. Procédé de fabrication selon la revendication 9, où, lors de l'étape de traitement de base, une pluralité de rainures d'ailettes (138C) sont formées sur la surface inférieure pour recevoir les extrémités distales de la pluralité d'ailettes de refroidissement (123C), et, lors de l'étape de connexion de base, la première et la deuxième bases (12C, 13C) sont raccordées l'une à l'autre dans un état où les extrémités distales de la pluralité d'ailettes de refroidissement (123C) sont insérées dans les rainures respectives de la pluralité de rainures d'ailette (138C).

11. Procédé de fabrication selon la revendication 9 ou la revendication 10, où, lors de l'étape de connexion de base, les surfaces intérieures de la première et de la deuxième bases (12C, 13C) sont brasées l'une à l'autre, et les extrémités distales de la pluralité d'ailettes de refroidissement (123C) sont brasées sur la surface inférieure.
